# EUROPÄISCHE PATENTANMELDUNG

(11) **EP 2 193 953 A2**
(43) Veröffentlichungstag der Anmeldung: **09.06.2010**
(21) Anmeldenummer: 09173407.9
(22) Anmeldetag: 19.10.2009
(51) Int. Cl.: B60K 37/06

(54) **Bedieneinrichtung und Verfahren zur Bedienung**

(30) Priorität: 04.12.2008 DE 102008044332
(71) Anmelder: Robert Bosch GmbH, 70442 Stuttgart (DE)
(72) Erfinder: Mietens, Stephan, 70437 Stuttgart (DE)

(57) **Zusammenfassung**

Die Erfindung betrifft eine Bedieneinrichtung insbesondere für ein Fahrzeug, mit einem Bedienelement (1, 40) und mit einer Auswerteeinheit (10, 44) zur Verarbeitung einer Betätigung einer mit dem Bedienelement (1, 40) vorgenommenen Eingabe, gekennzeichnet durch mehrere an dem Bedienelement angeordnete Sensoren (20, 41) zur Erfassung einer Berührung des Bedienelements durch wenigstens einen Finger bei einer Betätigung des Bedienelements, wobei die Auswerteeinheit (10, 44) in Abhängigkeit von dem erfassten Finger oder den jeweils erfassten Fingern bei der Betätigung des Bedienelements (81, 40) die Betätigung einem Bediener in einem jeweiligen Raumwinkelbereich in der Umgebung des Bedienelements zuordnet.

## Beschreibung

### Stand der Technik

Die Erfindung geht aus von einer Bedieneinrichtung oder einem Verfahren zur Bedienung nach Gattung der unabhängigen Ansprüche. Aus der DE 103 37 852 A1 ist bereits ein Fahrzeugsystem mit einer Bedieneinrichtung zur Bedienung des Fahrzeugsystems bekannt. Hierbei ist eine Einrichtung vorgesehen, die dazu ausgebildet ist, zu erkennen, ob ein Bedienzugriff auf die Bedieneinrichtung durch den Fahrzeugführer oder durch einen sonstigen Insassen des Fahrzeugs erfolgt. Eine Bedienung des Fahrzeugsystems wird dann in Abhängigkeit davon beeinflusst, ob ein Bedienzugriff durch den Fahrzeugführer oder den anderen Fahrzeuginsassen erfolgt ist. In einer ersten Ausführungsform ist dabei eine Kamera vorgesehen, deren Bilderfassungsbereich den Fahrer- und den Beifahrersitzplatz erfasst, um festzustellen, wer die Bedieneinrichtung bedient hat. In einer weiteren Ausführungsform ist eine Sprachbedienung vorgesehen, um festzustellen, welche Person Sprachbefehle eingegeben hat.

### Offenbarung der Erfindung

### Vorteile der Erfindung

Die erfindungsgemäße Bedieneinrichtung mit den Merkmalen des unabhängigen Anspruchs hat demgegenüber den Vorteil, dass über die Bedienung des Bedienelementes selbst festgestellt werden kann, wer die Bedienung vorgenommen hat. Hierzu sind an dem Bedienelement Sensoren vorgesehen, um festzustellen, in welcher Weise das Bedienelement mit einem bzw. mit mehreren Fingern betätigt wurde. In Abhängigkeit von der auf diese Weise mit dem einen oder den mehreren Fingern durchgeführten Betätigung des Bedienelements kann die Betätigung dabei einem Bediener in einem jeweiligen Raumwinkelbereich in der Umgebung des Bedienelements zugeordnet werden. Durch die Integration der Sensoren in das Bedienelement kann dabei eine Erfassung, wer die Bedienung durchgeführt hat, platzsparend und zuverlässig erfolgen. Durch die Zuordnung zu einem Bediener können wiederum dem jeweiligen Bediener bedarfsgerecht Funktionen bereitgestellt werden.

Entsprechende Vorteile ergeben sich auch für ein erfindungsgemäßes Verfahren zur Bedienung eines elektrischen Geräts.

Durch die in den abhängigen Ansprüchen aufgeführten Maßnahmen sind vorteilhafte Weiterbildungen und Verbesserungen der in dem unabhängigen Anspruch angegeben Bedieneinrichtung und des in dem unabhängigen Anspruch angegebenen Verfahrens zur Bedienung möglich. So ist es vorteilhaft, das Bedienelement als einen Drehregler auszuführen. Insbesondere bei einem Drehregler ist zu erwarten, dass eine Bedienung des Bedienelements einerseits abhängig von einer Position eines Bedieners gegenüber dem Bedienelement, andererseits aber unabhängig von einer Person des Bedieners in zumindest ähnlicher Weise erfolgen wird. Damit ist eine Zuordnung zwischen einem Raumwinkelbereich, in dem sich der Bediener vor dem Bedienelement befindet zu der jeweiligen Bedienung in besonders sicherer Weise möglich. Ferner ist es hierbei vorteilhaft, die Sensoren an einem Umfang des Drehreglers anzuordnen, um die Position der jeweils erfassten Finger bei der Bedienung auf leichte Weise und zuverlässig erfassen zu können.

Weiterhin ist es vorteilhaft, das Bedienelement als eine berührungsempfindliche Bedienfläche auszuführen. So kann bei einer Erfassung einer Bedienung insbesondere eine Richtungsinformation über die Ausrichtung eines Fingers gegenüber der berührungsempfindlichen Bedienfläche erfasst werden, um aus dieser Ausrichtung des Fingers auf einen jeweiligen Raumwinkelbereich zu schließen, aus dem eine Bedienung des jeweiligen Bedienelements erfolgt. Hierbei können für eine Erfassung eines Bedieners in der berührungsempfindliche Bedienfläche bereits für die Bedienung als solche vorhandene Sensoren mit ausgenutzt werden.

Weiterhin ist es vorteilhaft, einem Bediener eine Rückmeldung darüber zu geben, zu welchem Raumwinkelbereich eine jeweilige Zuordnung der Bedienung erfolgt ist. Ein Bediener hat damit die Sicherheit, dass tatsächlich auch die von ihm gewünschte Funktion durch die Bedienung ausgelöst wird. Es ist ferner vorteilhaft, dass für den Fall, dass eine eindeutige Zuordnung zu einem Bediener nicht möglich ist, eine entsprechende Warnung an einen Bediener auszugeben. Gegebenenfalls kann er dann eine Bedienung wiederholen, um eine eindeutige Zuordnung zu ermöglichen. Ferner ist es auch möglich, über ein weiteres Bedienelement gegebenenfalls in einem solchen Zweifelsfall eine entsprechende Zuordnung zu einem Raumwinkelbereich und damit zu einem Bediener manuell einzugeben.

Besonders vorteilhaft ist eine Verwendung einer Bedieneinrichtung in einem Kraftfahrzeug, insbesondere auf einer Mittelkonsole eines Kraftfahrzeugs. Denn bei einer Verwendung in einer Mittelkonsole in einem Fahrzeug ist eine Position der Benutzer gegenüber der Bedieneinrichtung eindeutig festgelegt, jeweils links oder rechts der Mittelkonsole. Bei einem linksgesteuerten Fahrzeug ist dies von links der Fahrer und von rechts der Beifahrer. Insbesondere bei einem Fahrzeug kann es wichtig sein, dass einem Fahrer während einer Fahrt nicht alle Funktionen zur Verfügung gestellt werden, um eine unnötige Ablenkung des Fahrers zu vermeiden, beispielsweise durch eine TV-Funktion. Ferner können Funktionen, wie beispielsweise eine Klimaregelung oder eine Sitzheizung, bei einer entsprechenden Zuordnung automatisch dem jeweiligen Bediener im Fahrzeug zugewiesen werden. Somit ist eine Einstellung für den Fahrer und den Beifahrer jeweils über ein Bedienelement möglich, ohne dass eine gesonderte manuelle Angabe, für wen die Einstellung erfolgen soll, erforderlich ist. Insbesondere für eine Anzeige, die für einen Fahrer und einen Beifahrer jeweils unterschiedliche Bilddarstellungen ermöglicht, kann eine auf die Bedienung bezogene Anzeige jeweils auch nur in demjenigen Bild der Anzeige dargestellt werden, das entsprechend der Person des Bedieners entweder für den Fahrer oder für den Beifahrer sichtbar ist.

Eine Zuordnung zu einem Bediener kann dabei vorteilhaft dadurch erfolgen, dass anhand der erfassten Positionen der Finger eine Bedienung durch eine linke oder eine Bedienung durch eine rechte Hand ermittelt wird. Insbesondere bei einer Verwendung in einem Fahrzeug ist davon auszugehen, dass eine Person, die links des Bedienelements sitzt, beispielsweise der Fahrer, bei einer Anordnung des Bedienelements in der Mittelkonsole, seine rechte Hand für die Bedienung des Bedienelement verwenden wird. Bei einem Beifahrer ist davon auszugehen, dass selbst ein ansonsten rechtshändiger Beifahrer für eine Bedienung des Bedienelementes in der Mittelkonsole die linke Hand verwenden wird. Somit ist durch eine Zuordnung der Bedienung zu einer Betätigung mit einer linken oder mit einer rechten Hand auch unmittelbar eine Zuordnung zu einer Person des Fahrer bzw. des Beifahrers möglich.

Weiterhin ist es vorteilhaft, bei einer Ausführung des Bedienelements als Drehregler eine Bedienung durch eine rechte Hand dann zu erfassen, wenn mehrere Finger an der rechten Seite des Drehreglers erfasst werden, da eine anderweitige Position der Finger im Allgemeinen zu einer ungünstigen Handstellung führen würde. Entsprechendes gilt für eine Bedienung mit einer linken Hand. Alternativ oder ergänzend kann auch die Position eines einzelnen Fingers, im Allgemeinen eine Positionierung des Daumens, an dem Drehregler ausgewertet werden, sodass der Daumen sich gegenüber den mehreren Fingern an einem Außenumfang des Drehreglers befinden muss.

### Kurze Beschreibung der Zeichnungen

Ausführungsbeispiele der Erfindung sind in den Zeichnungen dargestellt und in der nachfolgenden Beschreibung näher erläutert.
Es zeigen
Figuren 1 und 2 verschiedene Ansichten einer erfindungsgemäßen Bedieneinrichtung in einer Ausführungsform als ein Drehregler,
Figur 3 eine Anzeigendarstellung zur Darstellung einer Funktionsauswahl und zur Darstellung einer Zuordnung einer Bedienung zu einem Bediener,
Figur 4 ein weiteres Ausführungsbeispiel einer erfindungsgemäßen Bedieneinrichtung als eine berührungsempfindliche Bedienfläche,
Figur 5 eine Anordnung einer als ein Drehregler ausgeführten Bedieneinrichtung in einem Kraftfahrzeug.

### Ausführungsformen der Erfindung

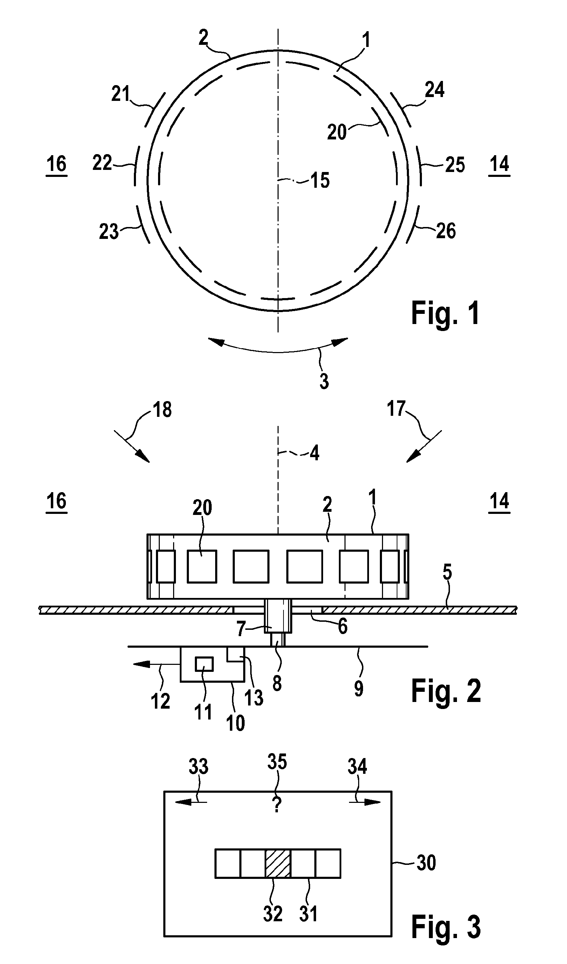

In den Figuren 1 und 2 ist ein erstes Ausführungsbeispiel einer Bedieneinrichtung dargestellt. Ein Drehregler 1, der an seinem Außenumfang 2 von Fingern einer Hand umgriffen werden kann, kann zur Einstellung bzw. zur Auswahl einer mit dem Drehregler steuerbaren Funktion in Pfeilrichtung 3 gedreht werden. Der Drehregler 1 rotiert dabei um eine in der Figur 2 gestrichelt dargestellte Drehachse 4. In einer Ausführungsform ist der Drehregler dabei oberhalb einer Abdeckung 5 angeordnet, die beispielsweise als ein Gehäuse des zu bedienenden elektrischen Gerätes ausgeführt ist. Ferner kann bei einer Anordnung in einem Kraftfahrzeug die Abdeckung 5 auch als eine Instrumententafel ausgeführt sein. Durch eine Öffnung 6 in der Abdeckung 5 kann eine Drehung des Drehreglers 1 über ein Verbindungsstück 7 auf eine elektrische Kontakteinheit 8 übertragen werden, die bei einer Drehung des Drehreglers 1 elektrische Signale übermittelt, die über eine Leiterplatte 9 an eine Auswerteeinheit 10 weitergegeben werden. Die Auswerteeinheit 10 weist eine Recheneinheit 11 auf, die die Signale auswertet und über eine Datenschnittstelle 12 an weitere Komponenten zur Ausführung der über den Drehregler 1 gewählten Funktion weiterleitet.

An dem Umfang 2 des Drehreglers 1 sind berührungsempfindliche Sensorelemente 20 angeordnet, die jeweils einzelnen Flächenbereichen des Umfangs 2 des Drehreglers zugeordnet sind. Aus Gründen der Übersichtlichkeit der Zeichnung ist lediglich eines der Sensorelemente 20 mit einem Bezugszeichen versehen. In einer ersten Ausführungsform sind die Sensorelemente 20 als druckempfindliche Elemente ausgeführt, die einen Druck auf den Umfang 2 des Drehreglers 1 registrieren. In einer anderen Ausführungsform ist es auch möglich, eine Berührung des Umfangs 2 elektronisch zu erfassen, beispielsweise durch eine Kapazitätsänderung, die durch eine Annäherung des Fingers an einer relevanten Stelle des Umfangs 2 bewirkt wird. Die Sensoren 20 werden vorzugsweise von der Auswerteeinheit 10 ausgewertet, indem die Informationen der Sensoren über das Verbindungsstück 7 und die elektrische Kontakteinheit 8 an die Auswerteeinheit 10 weitergeleitet werden. In einer weiteren Ausführungsform ist es auch möglich, eine Recheneinheit zur Aufbereitung der von den Sensoren 20 erfassten Informationen bereits in den Drehregler 1 selbst zu integrieren.

In einer Ausführungsform weist die Auswerteeinheit 10 einen Speicher 13 auf, in dem wenigstens eine Auswertevorschrift abgelegt ist, um einer Berührung des Umfangs 2 eine jeweilige Richtung zuzuordnen, aus der eine Berührung erfolgt ist. Bei der hier gezeigten Ausführungsform erfolgt hierbei eine Zuordnung entweder zu einem ersten Raumwinkelbereich 14, der sich rechts der strichpunktierten Linie 15 gemäß der Figur 1 befindet. Oder es erfolgt eine Bedienung aus einem Raumwinkelbereich 16, der sich links der Linie 15 befindet. Ein Betrachter, der sich schräg vor dem Drehregler 1 in dem Raumwinkelbereich 14 befindet würde also entsprechend einer dargestellten Pfeilrichtung 17 den Drehregler 1 beobachten. Entsprechend würde aus dem Raumwinkelbereich 16 ein Beobachter entsprechend der dargestellten Pfeilrichtung 18 den Drehregler 1 beobachten.

In der Figur 1 sind ferner drei Berührungsbereiche 21, 22, 23 an einer Seite des Drehreglers zugeordnet dem zweiten Raumwinkelbereich 16 vorgesehen und auf der gegenüberliegenden Seite drei weitere Berührungsbereiche 24, 25, 26. Zusammen sind somit sechs Berührungsbereiche gemäß der Figur 1 definiert. Ein Betrachter, der aus Pfeilrichtung 17 aus dem ersten Raumwinkelbereich 14 den Drehregler 1 bedient, wird mit seinem Zeigefinder in dem dritten Berührungsbereich 23, mit seinem Mittelfinger in dem ersten Berührungsbereich 21 und mit seinem Daumen in dem fünften Berührungsbereich 25 den Drehregler berühren. Fast er den Drehregler nur mit zwei Fingern an, so wird er mit dem Zeigefinder oder dem Mittelfinder einen der ersten drei Berührungsbereiche 21, 22, 23 und mit dem Daumen einen jeweils gegenüberliegenden Berührungsbereich 26, 25 bzw. 24 berühren. Durch die entsprechenden Sensorelemente kann eine Berührung mit den jeweiligen Fingern einem der jeweiligen Berührungsbereiche zugeordnet werden.

Wird eine dieser Berührungen erfasst, so wird eine Berührung des Drehreglers 1 durch eine rechte Hand von der Auswerteeinheit 10 ermittelt. Die nachfolgende Bedienung wird also einem Bediener in dem ersten Raumwinkelbereich 14 zugeordnet. Von einem Bediener in diesem Raumwinkelbereich wird erwartet, dass er den Drehregler mit der rechten Hand bedienen wird.

In vergleichbarer Weise kann auch eine Bedienung durch eine linke Hand erfasst werden. Berührt also ein Benutzer in dem zweiten Raumwinkelbereich 16 den Drehregler 1, so ist entsprechend zu erwarten, dass ein Zeigefinger den sechsten Berührungsbereich 26, der Mittelfinder den dritten Berührungsbereich 24 und der Daumen den zweiten Berührungsbereich 22 erfasst. Bei einer Bedienung mit zwei Fingern wird der Daumen einen der Bereiche 21, 22, 23 und der Mittel- bzw. Zeigefinger die entsprechenden, gegenüberliegenden Bereiche 26, 25, 24 erfassen.

Die Berührungsbereiche sind raumfest definiert und die jeweilige Zuordnung ist in dem Speicher 13 abgelegt. Wird der Drehregler 1, der vorzugsweise als ein Endlosdrehregler ausgeführt ist, gedreht und wird nach der Drehung ein Loslassen des Drehreglers 1 erfasst, werden die entsprechenden Berührungsbereiche an ihrem ursprünglichen Ort in Bezug auf die Abdeckung 5 wieder initialisiert.

Wird eine Bedienung mit mehreren Fingern auf einer Seite des Drehreglers und mit dem Daumen auf der gegenüberliegenden Seite erfasst, so ist es ausreichend, dass die Sensoren 20 lediglich eine Berührung der Finger überhaupt erfassen, ohne eine Spezifizierung der Finger vornehmen zu müssen. Um auch ein zuverlässiges Ergebnis für den Fall zu erreichen, dass eine Bedienung mit einem Finger auf einer Seite und mit einem anderen Finger auf der anderen Seite erfolgt, so kann zusätzlich die Breite oder die Größe einer Fläche einer Berührung ausgewertet werden, da an derjenigen Stelle, an der der Daumen den Umfang 2 des Drehreglers 1 berührt, eine räumliche größere Ausdehnung einer Berührungsfläche gegenüber den Berührungen durch die anderen Finger zu erwarten ist.

In der Figur 3 ist ein Ausführungsbeispiel für eine Anzeige 30 dargestellt, die beispielsweise benachbart zu dem Drehregler 1 angeordnet ist und die hinsichtlich einer Funktionsauswahl mit dem Drehregler 1 zusammenwirkt. Hierzu kann ein Auswahlfeld 31 in der Anzeige dargestellt werden, indem eine Anzeigemarke 32 hervorgehoben ist. Durch eine Drehung des Drehreglers 1 kann die Anzeigemarke 32 entsprechend der Drehrichtung des Drehreglers 1 in dem Funktionsauswahlfeld 31 verschoben werden. In einer ersten Ausführungsform kann durch die Verschiebung der Anzeigemarke 32 bereits unmittelbar eine entsprechende Funktion ausgewählt werden, beispielsweise eine Lautstärkenregelung oder eine Temperatureinstellung können verändert werden. In einer anderen Ausführungsform ist es auch möglich, dass nach einer Auswahl einer dargestellten Funktion durch eine Drehung des Drehreglers zur Ausführung der Funktion noch eine nachfolgende Bestätigung der ausgewählten Funktion erforderlich ist. In einer ersten Ausführungsform kann hierzu ein gesondertes Bestätigungselement vorgesehen sein. Ferner ist es aber auch möglich, dass eine Bestätigung beispielsweise durch eine axiale Bewegung des Drehreglers 1 eingegeben werden kann.

Um dem Benutzer anzuzeigen, welchem Bediener eine jeweilige, mit dem Drehregler 1 durchzuführende Eingabe zugeordnet wird, sind in dem hier dargestellten Ausführungsbeispiel ein erstes Symbol 33 und ein zweites Symbol 34 vorgesehen, durch deren Aktivierung einem jeweiligen Bediener angezeigt wird, wem eine entsprechende Bedienung zugeordnet wird.

In einer weiteren Ausführungsform ist es bei einem Bildschirm vorteilhaft, der für verschiedene Raumwinkelbereiche unterschiedliche Bilder darstellt, eine Aktivierungsmarke in dem für diejenige Raumwinkelrichtung sichtbaren Bild darzustellen, der einer entsprechenden Bedienung des Drehreglers 1 zugeordnet wird.

Ferner ist es auch vorteilhaft, eine Anzeigemarke 35 für den Fall vorzusehen, dass eine Zuordnung nicht eindeutig erfolgt ist. In diesem Fall unterbleibt gemäß einer Ausführungsform zunächst eine Ausführung der Funktion. Ein Bediener kann nun die von ihm ausgewählte Funktion erneut aufrufen, um eine dem Bediener zugeordnete Ausführung der Funktion zu erhalten.

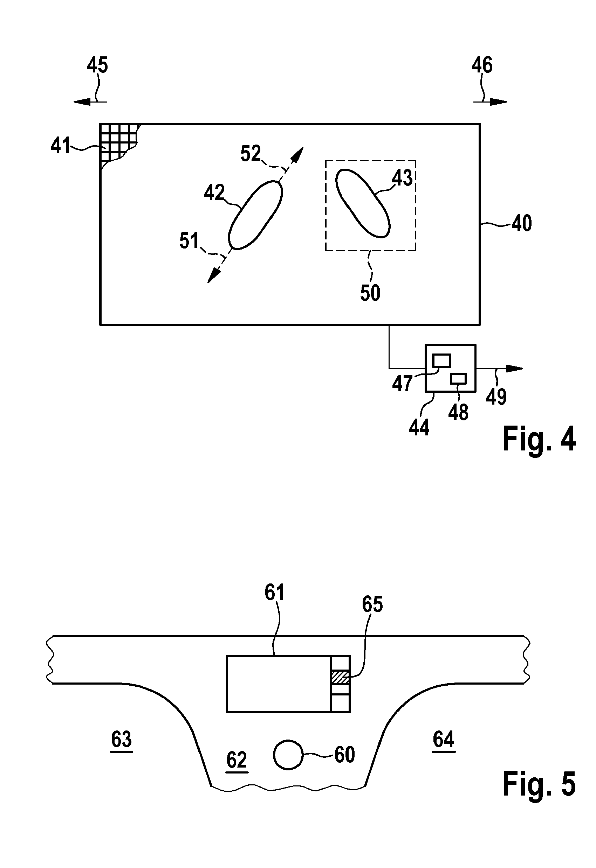

In der Figur 4 ist ein weiteres Ausführungsbeispiel für eine erfindungsgemäße Bedieneinrichtung dargestellt. Hierbei ist eine berührungsempfindliche Fläche 40 vorgesehen, die beispielsweise als ein Touchpanel oder als ein Touchscreen-Bildschirm ausgeführt ist. Die berührungsempfindliche Oberfläche weist einzelne Matrixelemente 41 auf, die jeweils einer Position auf der berührungsempfindlichen Oberfläche eine Berührung zuordnen können. Erfolgt nun eine Bedienung, bei der ein Benutzer nach rechts greifen muss, um die berührungsempfindliche Oberfläche 40 zu erreichen, so wird eine entsprechende Ausrichtung einer Berührung durch einen Finger von links unten nach recht oben verlaufen, sodass sich ein entsprechendes Berührungsfeld 42 ergibt. Wird eine Benutzung derart erfolgen, dass ein Benutzer mit seiner linken Hand nach links greifen muss, um die berührungsempfindliche Oberfläche 40 zu erreichen, so wird sich ein entsprechendes Berührungsfeld von links oben nach rechts unten gemäß dem Berührungsfeld 43 in der Figur 4 ergeben. Eine Berührung kann von einer Auswerteeinheit 44 ausgewertet werden und eine Funktion in Abhängigkeit von einer Berührung von links oder von rechts ausgelöst werden. Hierbei wird in einem Berührungsfeld 42 eine Berührung aus einem Raumwinkelbereich links von der berührungsempfindlichen Oberfläche, also in Pfeilrichtung 45 zugeordnet, während einem Berührungsfeld 43 ein Raumwinkelbereich rechts, also in Pfeilrichtung 46, rechts von der berührungsempfindlichen Oberfläche 40 zugeordnet wird. Zur Auswertung weist die Auswerteeinheit 44 eine Recheneinrichtung 47 auf, wobei die Zuordnung zu jeweiligen Raumwinkelbereichen in einer Speichereinheit 48 abgelegt ist. Über eine Ansteuerleitung 49 kann eine jeweilige durchzuführende Bedienung an ein elektrisches Gerät oder an weitere Komponenten weitergeleitet werden. Eine Bedienung kann dabei derart erfolgen, dass eine Auslösung einer Funktion einem Auslösefeld 50 dann zugeordnet wird, wenn eine Berührung innerhalb des Auslösefeldes 50 festgestellt wird. Ferner kann aber auch, ähnlich einem Schieberegler eine lineare Bewegung erfasst und zur Funktionsteuerung verwendet werden, also beispielsweise eine lineare Bewegung in Pfeilrichtung 51 oder 52.

Eine beispielhafte Anordnung eines Drehreglers 60 ist in der Figur 5 dargestellt. Der Drehregler ist hierbei benachbart zu einer Anzeigefläche 61 in einer Mittelkonsole 62 eines Fahrzeugs angeordnet. Links von der Mittelkonsole ist ein Fahrerplatz 63 vorgesehen, während recht von der Mittelkonsole 62 ein Beifahrerplatz 64 vorgesehen ist. In der Anzeigefläche 61 können verschiedene Fahrzeugfunktionen wie beispielsweise Klimafunktionen, eine Sitzeinstellung oder eine Navigationsfunktion dargestellt werden. Ferner ist es auch möglich, Unterhaltungsfunktionen darzustellen, wie beispielsweise eine Auswahl eines Radioprogramms oder eine Ausgabe eines Fernsehprogramms. In einer Ausführungsform kann dabei die Anzeige 61 so ausgeführt sein, dass von dem Fahrerplatz 63 und von dem Beifahrerplatz 64 jeweils ein unterschiedliches Bild sichtbar ist. Eine Auswahl von Funktionen in der Anzeige 61 erfolgt über den Drehregler 60 jeweils der Position des Beifahrers 64 oder der Position der Fahrers 63 zugeordnet. Beispielsweise kann eine Auswahl aus einzelnen Funktionsfeldern 65 erfolgen, die in der Anzeige 61 dargestellt sind.

## Patentansprüche

**1.** Bedieneinrichtung insbesondere für ein Fahrzeug, mit einem Bedienelement (1, 40) und mit einer Auswerteeinheit (10, 44) zur Verarbeitung einer Betätigung einer mit dem Bedienelement (1, 40) vorgenommenen Eingabe, **gekennzeichnet durch** mehrere an dem Bedienelement angeordnete Sensoren (20, 41) zur Erfassung einer Berührung des Bedienelements **durch** wenigstens einen Finger bei einer Betätigung des Bedienelements, wobei die Auswerteeinheit (10, 44) in Abhängigkeit von dem erfassten Finger oder den jeweils erfassten Fingern bei der Betätigung des Bedienelements (81, 40) die Betätigung einem Bediener in einem jeweiligen Raumwinkelbereich in der Umgebung des Bedienelements zuordnet.

**2.** Bedieneinrichtung nach Anspruch 1, **dadurch gekennzeichnet, dass** das Bedienelement (1) ein Drehregler ist.

**3.** Bedieneinrichtung nach Anspruch 2, **dadurch gekennzeichnet, dass** die Sensoren (20) an einem Umfang des Drehreglers (1) angeordnet sind.

**4.** Bedieneinrichtung nach Anspruch 1, **dadurch gekennzeichnet, dass** das Bedienelement (40) eine berührungsempfindliche Bedienfläche ist.

**5.** Bedieneinrichtung nach einem der vorhergehenden Ansprüche, **gekennzeichnet durch** eine Schnittstelle (12) zu einer Ausgabeeinheit zur Ausgabe einer Zuordnung zu einem Raumwinkelbereich und/oder zur Ausgabe einer Warnung für den Fall, dass keine eindeutige Zuordnung zu einem Raumwinkelbereich möglich ist.

**6.** Verwendung einer Bedieneinrichtung nach einem der vorhergehenden Ansprüche für ein Bedienelement insbesondere auf der Mittelkonsole eines Kraftfahrzeugs zur Bedienung einer Fahrzeugeinrichtung, wobei eine vorgenommene Bedienung des Bedienelements entweder einem Raumwinkelbereich eines Fahrerplatzes oder einem Raumwinkelbereich eines Beifahrerplatzes zugeordnet wird.

**6.** Verfahren zur Bedienung eines elektrischen Geräts, insbesondere einer Fahrzeugeinrichtung, wobei eine Betätigung eines Bedienelements (1, 40) erfasst wird und wobei in Abhängigkeit von der Bedienung eine Ausführung einer Funktion des elektrischen Geräts veranlasst wird, **dadurch gekennzeichnet, dass** bei der Betätigung des Bedienelements (1, 40) wenigstens eine Position eines Fingers eines Bedieners erfasst wird und dass eine Funktion in Abhängigkeit von der Position des wenigstens einen Fingers oder den Positionen der Finger ausgeführt wird.

**7.** Verfahren nach Anspruch 6, **dadurch gekennzeichnet, dass** anhand der erfassten Positionen der Finger eine Betätigung durch eine linke oder durch eine rechte Hand festgestellt wird.

**8.** Verfahren nach Anspruch 7, **dadurch gekennzeichnet, dass** Bedienelement als ein Drehregler ausgeführt ist und bei einer Berührung einer linken Seite des Drehreglers mit mehreren Fingern eine Betätigung durch eine linke Hand und bei einer Berührung einer rechten Seite des Drehreglers mit mehreren Fingern eine Betätigung durch eine rechte Hand festgestellt wird.

**9.** Verfahren nach einem der Ansprüche 7-8, **dadurch gekennzeichnet, dass** Bedienelement (1) als ein Drehregler ausgeführt ist und bei einer Berührung einer linken Seite des Drehreglers nur mit einem Daumen eine Betätigung durch eine rechte Hand und bei einer Berührung einer rechten Seite des Drehreglers nur mit einem Daumen eine Betätigung durch eine linke Hand festgestellt wird.

**10.** Verfahren nach einem der Ansprüche 6-7, **dadurch gekennzeichnet, dass** zudem eine Ausrichtung eines Fingers bei der Berührung des Bedienelements (40) erfasst wird.
